# EUROPÄISCHE PATENTSCHRIFT

(11) **EP 1 883 713 B1**
(45) Veröffentlichungstag und Bekanntmachung des Hinweises auf die Patenterteilung: **02.11.2011**
(21) Anmeldenummer: 06753591.4
(22) Anmeldetag: 13.05.2006
(51) Int. Cl.: C22C 9/10, C22C 9/06, F16C 33/12, F16C 33/14, B32B 15/01, C22F 1/08

(54) **GLEITLAGERVERBUNDWERKSTOFF, VERWENDUNG UND HERSTELLUNGSVERFAHREN**
PLAIN BEARING COMPOSITE MATERIAL, USE THEREOF AND PRODUCTION METHODS THEREFOR
MATERIAU COMPOSITE POUR PALIERS LISSES, UTILISATION ET PROCEDES DE FABRICATION

(30) Priorität: 13.05.2005 DE 102005023306
(43) Veröffentlichungstag der Anmeldung: 06.02.2008
(73) Patentinhaber: Federal-Mogul Wiesbaden GmbH, 65201 Wiesbaden (DE)
(72) Erfinder: ANDLER, Gerd, 65307 Bad Schwalbach (DE)
(74) Vertreter: Mehler Achler
(86) Internationale Anmeldenummer: PCT/EP2006/004507
(87) Internationale Veröffentlichungsnummer: WO 2006/120018

(56) Entgegenhaltungen:
- DE-A1- 1 558 474
- US-A1- 2003 099 853

## Beschreibung

Die Erfindung betrifft einen Gleitlagerverbundwerkstoff gemäß Anspruch 1. Ferner bezieht sich die Erfindung auf eine Verwendung und auf Herstellungsverfahren.

Aus der DE 44 15 629 C1 ist die Verwendung einer Kupfer-Nickel-Siliziumlegierung für die Herstellung von verschleißfesten Gegenständen mit Notlaufeigerischaften, wie beispielsweise Gießkolben von Druckgießmaschinen bekannt. Die in der DE 44 15 629 C1 beschriebene Legierung besteht aus 1-4% Nickel, 0,1 -1,5% Silizium und Rest Kupfer und wird als Massivwerkstoff eingesetzt.

Die US 2,137,282 beschreibt eine Legierung aus 0,1 - 30% Nickel, 0.05 - 3% Silizium und Rest Kupfer. Diese Legierung zeichnet sich nach entsprechender Wärmebehandlung durch große Härten und gute elektrische Leitfähigkeiten aus.

Die US 1,658,186 beschreibt eine Kupfer-Nickel-Siliziumlegierung, wobei ausführlich die als Hartteilchen wirkenden Silizide diskutiert werden. Verschiedene Wärmebehandlungsverfahren zur Einstellung der Härte werden angegeben.

Eine weitere Kupfer-Nickel-Siliziumlegierung findet sich in US 2,241,815, wobei der Nickelanteil bei 0,5 - 5% und der Siliziumanteil bei 0,1-2% liegt.

Auch in der DE 15 58 474 A1 ist eine Kupfer-Nickel-Siliziumlegierung mit 0,8 -10% Nickel und 0,2 - 2% Silizium offenbart, der zum Erzielen einer hohen Formänderungsfähigkeit bei möglichst geringer vorgeschalteter Kaltverformung gezielt 0,01 - 0,5% Eisen und 0,05 - 0,5% Chrom zulegiert werden.

Die US 2,185,958 beschreibt Legierungen aus 1 % Nickel, 3,5% Silizium und Rest Kupfer sowie aus 1,5% Silizium und 1 % Nickel sowie Rest Kupfer.

Aus der DE 36 42 825 C1 ist ein Gleitlagerwerkstoff bestehend aus 4 bis 10% Nickel, 1-2% Aluminium, 1-3% Zinn und Rest Kupfer sowie übliche Verunreinigungen bekannt, der eine hohe Festigkeit und große Lebensdauer aufweisen soll. Aus diesem Gleitlagerwerkstoff werden Vollmaterialbuchsen hergestellt.

Die GB 2384007 beschreibt einen Gleitlagervertiundwerkstoff mit einem Stahlrücken, auf dem eine Sinterschicht aus einer Kupferlegierung aufgebracht ist, die eine Härte von max. 130 HV aufweist. Die Kupferlegierung weist 1-11 Gew.% Zinn, bis 0,2 Gew.% Phosphor, max. 10 Gew.% Nickel oder Silber, max. 25 Gew.% Blei und Wismut auf.

Gleitlagerverbundwerkstoffe bei denen eine Gleitschicht auf eine Lagermetallschicht aufgesputtert ist, sind mit Zwischenschichten aus Nickel; aus einer Nickellegierung, aus Nickel-Chrom, aus Zink oder aus einer Zinklegierung versehen, wie dies in DE 43 28 921 A1 beschrieben wird. Wenn eine Cu-Legierung als Lagerlegierung verwendet wird, und wenn eine Sn-enthaltende Legierung für die oberste Schicht verwendet wird, dann diffundiert das Sn im Verlauf der Zeit in die Cu-Legierung hinein, wodurch der Sn-Gehalt der obersten Schicht verringert wird. Zur gleichen Zeit wird eine brüchige CuSn-Verbindung an der Verbindungsoberfläche erzeugt, wodurch die Bindungsfestigkeit erniedrigt wird. Im Hinblick darauf wird die Zwischenschicht aus Ni oder einer Ni-Legierung auf der Lagerlegierung durch Aufspritzen bzw. Aufsprühen oder durch Elektroplattieren gebildet. Darauf wird dann durch Dampfabscheidung die oberste Schicht gebildet, wodurch eine stabilere Bindung erhalten werden kann.

Diffusionssperrschichten werden auch in der DE 28 53 774 erwähnt.

Die DE 195 25 330 beschreibt einen Schichtwerkstoff, bei dem unmittelbar auf einen Trägerwerkstoff ein Lagerwerkstoff aufgesputtert wird. Als Trägerwerkstoff kann ein Stahlstützmetall verwendet werden, auf das der Lagerwerkstoff ohne weitere Zwischenschicht aufgebracht werden kann. Es besteht aber auch die Möglichkeit, als Trägerwerkstoff einen kupferhaltigen, insbesondere einen Trägerwerkstoff aus einer Kupfer-Blei-Zinn-Legierung zu verwenden. Beispielsweise kann der Trägerwerkstoff aus CuPb22Sn bestehen.

Wenn der Bleianteil des Trägerwerkstoffes in der Größenordnung des Bleianteils des Lagerwerkstoffes liegt, besteht zwischen beiden Materialien kein oder nur ein geringes Konzentrationsgefälle, so dass auch keine Diffusionsvorgänge zwischen dem Lagerwerkstoff und dem Trägerwerkstoff stattfinden können. Wenn der Trägerwerkstoff eine höhere Bleikonzentration als der Lagerwerkstoff aufweist, wird die Abwanderung des Bleis an die Oberfläche des Lagerwerkstoffes zusätzlich begünstigt. Die Kupfer-Blei-Zinn-Legierung, die den Trägerwerkstoff bildet, kann auf ein Stahlstützmetall gießplattiert sein.

Aufgabe der Erfindung ist es, einen Gleitlagerverbundwerkstoff mit aufgesputterten Gleitschichten zur Verfügung zu stellen, der hinsichtlich seiner Festigkeits- und tribologischen Eigenschaften mit den bekannten Verbundwerkstoffen vergleichbar ist, wobei unabhängig von der Zusammensetzung der Gleitschicht auf Diffusionssperrschichten verzichtet werden kann. Es ist auch Aufgabe, eine Verwendung und Herstellungsverfahren anzugeben.

Diese Aufgabe wird mit einem Gleitlagerverbundwerkstoff gemäß Patentanspruch 1 gelöst.

Es hat sich herausgestellt, dass bei den beanspruchten Kupferlegierungen mit Nickel- und Siliziumanteilen diese Komponenten diffusionshemmend, insbesondere auf Aluminium und Zinn einwirken, so dass es fast nicht zu einer Diffusion kommt. Eine geringe Diffusion kann nie ausgeschlossen werden, es bildet sich hierbei aber nur eine extrem dünne Zwischenschicht aus, die nicht zu einer Ablösung der auf der Kupferlegierung aufgebrachten Gleitschicht führt.

Es hat sich gezeigt, dass Kupferlegierungen mit Nickel-Silizium hinsichtlich ihrer mechanischen und tribologischen Eigenschaften in einem weiten Bereich eingestellt werden können, so dass eine Anpassung an die geforderten Eigenschaften möglich ist.

Der Stahlrücken gewährleistet aufgrund seiner Steifigkeit den erforderlichen Presssitz, so dass die Gefügestruktur des Lagermaterials unabhängig von Festigkeitsanforderungen eingestellt werden kann. Die beanspruchten Kupferlegierungen können somit bezüglich ihrer Gefügestruktur beispielsweise so gestaltet werden, dass sie hinsichtlich Festigkeit und Härte sowie der tribologischen Eigenschaften, wie das Fressverhalten, in einem vergleichbaren Bereich wie die klassischen Blei-Bronzelager liegen.

Insgesamt wird der Einsatzbereich des Gleitlagerverbundwerkstoffes wesentlich erweitert.

Auch bieten die Verbundwerkstoffe mit Stahlrücken Vorteile aufgrund ihres thermischen Ausdehnungskoeffizienten in Anwendungsfällen mit Stahlgehäusen.

Die Einstellung der tribologischen Eigenschaften des Lagermetalls erfolgt vorzugsweise durch eine thermomechanischen Behandlung, insbesondere durch Walzen und Glühen.

Eine solche thermomechanische Behandlung des Verbundwerkstoffes kann derart gestaltet werden, dass die für das Fertigteil notwendigen Eigenschaften des Stahls nicht beeinträchtigt werden.

Das erfindungsgemäße Herstellungsverfahren sieht gemäß einer ersten Alternative folgende Verfahrensschritte vor

Herstellen von Bandmaterial aus einer Kupfer-Nickel-Silizium-Legierung und Walzplattieren des Bandmaterials auf einer Trägerschicht aus Stahl zur Herstellung eines Verbundes. Hierbei erfolgt eine Umformung des Lagermetalls und/oder Stahls von 50 - 70 %.

Die anschließende thermomechanische Behandlung sieht folgende Schritte vor:
erstes Glühen des Verbundes bei 550°C bis 700°C für 2 bis 5 Stunden, mindestens ein erstes Walzen des Verbundes, wobei ein Umformgrad von 20 bis 30 % durchgeführt wird,

mindestens ein zweites Glühen bei 500°C - 600°C für mehr >1 h,
gegebenenfalls ein zweites Walzen des Verbundes, wobei ein Umformgrad von max. 30 % durchgeführt wird mit einem anschließenden dritten Glühen bei Temperaturen >500°C über mindestens 1 h.

Gemäß weiterer Alternativen wird die Kupferlegierung auf die Trägerschicht aufgetragen und gesintert oder aufgegossen.

Mittels des ersten bzw. des zweiten Walzschrittes in Kombination mit der sich daran anschließenden Glühung wird die Streckgrenze des Lagermetalls eingestellt, wobei vorzugsweise die Streckgrenze des Lagermetalls bei 150 bis 250 MPa liegt.

Wenn nach dem zweiten Glühen das Endmaß erreicht worden ist, wird die thermo-mechanische Behandlung beendet. Die Streckgrenze wird in diesem Fall durch das erste Walzen und das zweite Glühen eingestellt.

Wenn nach dem zweiten Glühen das Endmaß noch nicht erreicht ist, schließt sich das zweite Walzen und eine dritter Glühschritt an, wodurch die Streckgrenze auf den angegebenen Wert eingestellt wird.

Das Gefüge nach der thermo-mechanischen Behandlung zeichnet sich durch feine, gleichmäßig isotrop verteilte intermetallische Ausscheidungen auf NiSi-Basis innerhalb der Kupfermatrix aus.

Die genannte Streckgrenze des Lagermetalls liegt deutlich unter der von Stahl, was deswegen möglich ist, weil hier die Stahlträgerschicht für den erforderlichen Presssitz sorgt. Der Vorteil der erfindungsgemäßen Verbundwerkstoffe besteht darin, dass die Streckgrenze des Lagermetalls soweit abgesenkt werden kann, bis die gewünschten tribologischen Eigenschaften, insbesondere die Anpassungsfähigkeit der Lagermetallschicht, erreicht werden, d. h., dass es z. B. zu keinem oder nur geringem Verschleiß des Gegenläufers kommt.

Vom Verbund werden zur Herstellung von Gleitlagerelementen nach dem Längsteilen Platinen abgetrennt und die Platinen durch bekannte Umformschritte zu Gleitlagerelementen umgeformt. Der abschließende Prozess stellt vorzugsweise das Gleitlagerbearbeiten und das Aufbringen der Gleitschicht dar.

Die Gleitschicht wird mittels eines PVD-Verfahrens, insbesondere mittels Sputtern, aufgetragen. Gegebenenfalls wird auf die Gleitschicht noch eine Einlaufschicht aufgebracht.

Durch die Gleitschicht werden die tribologischen Eigenschaften des Verbundwerkstoffs weiter verbessert.

In der Kupfer-Nickel-Siliziumlegierung liegt der Nickelanteil bei 0,5 - 5 Gew.%, vorzugsweise bei 1,0 bis 3,0 Gew.%, insbesondere bei 1,5 bis 2,2 Gew.%, und der Siliziumanteil bei 0,2 - 2,5 Gew.%, vorzugsweise bei 0,4 bis 1,2 Gew.% oder bei 0,5 bis 1,5 Gew.%.

Die Kupfer-Nickel-Silizium-Legierung kann 0,05 - 2,0 Gew.% Mangan, vorzugsweise 0,15- 1,5 Gew.% aufweisen.

Es hat sich gezeigt, dass bei einem Gewichtsverhältnis von Nickel zu Silizium zwischen 2,5 und 5 (Nickel: Silizium = 2,5 bis 5) die tribologischen Eigenschaften verbessert werden können, insbesondere ein Fressen des Lagerwerkstoffes deutlich verringert werden kann. Bei diesen Gewichtsverhältnissen werden die für die guten tribologischen Eigenschaften verantwortlichen Nickel-Silizium-Verbindungen begünstigt und in ausreichendem Maße gebildet.

Die Kupferlegierungen können weitere Mikrolegierungselemente aufweisen. Vorzugsweise weist die Trägerschicht 0,05 - 0,4 Gew.%, vorzugsweise 0,075 bis 0,25 Gew.%, mindestens eines Mikrolegierungselementes auf. Als Mikrolegierungselemente kommen beispielsweise Chrom, Titan, Zirkon, Zink und Magnesium einzeln oder in Kombination in Frage.

Vorzugsweise besteht zwischen der Lagermetallschicht und der Trägerschicht gegebenenfalls über eine Zwischenschicht eine Walzplattierverbindung. Für die Zwischenschicht können Kupfer oder eine Kupferlegierung, wie z.B. eine Kupfer-Zink-Legierung oder eine Kupfer-Zinn-Legierung eingesetzt werden.

Die Lagermetallschicht kann auch eine Sinterschicht oder eine Gießschicht sein, wobei Sintertemperaturen zwischen 600°C und 800°C über 10-30 min bzw. Begießtemperaturen von 1000°C bis 1250°C eingesetzt werden. In den Sinterprozess ist ein erstes Glühen integriert.

Sputter-Schichten bestehen vorzugsweise aus einer Aluminium-Zinn-Legierung, Aluminium-Zinn-Silizium-Legierung, Aluminium-Zinn-Kupfer-Legierung, einer Aluminium-Zinn-Silizium-Kupfer-Legierung oder einer Aluminium-Zinn-Nickel-Mangan-Legierung.

Vorzugsweise beträgt in diesen Legierungen der Zinnanteil 8-40 Gew.%, der Kupferanteil 0,5 - 4,0 Gew.%, der Siliziumanteil 0,02 - 5,0 Gew.%, der Nickelanteil 0,02 - 2,0 Gew.% und der Mangananteil 0,02 - 2,5 Gew.%.

Es hat sich gezeigt, dass sich bei diesen Sputter-Schichten in Kombination mit den beanspruchten Kupferlegierungen keine Sprödphasen bilden, die zur Ablösung der Gleitschicht führen. Es kann daher auf die Zwischenschicht verzichtet werden, wodurch erhebliche Kosteneinsparungen erzielt werden.

Die Dicke der Lagermetalischicht liegt vorzugsweise bei 0,1 - 0,8 mm, vorzugsweise bei 0,1 - 0,5 mm, insbesondere bei 0,15 - 0,35 mm.

Die Dicke der Gleitschicht beträgt vorzugsweise 4 - 30 µm, vorzugsweise 8 - 20 µm, insbesondere 10 - 16 µm.

Die Dicke der Einlaufschicht liegt bei 0,2-12 µm, vorzugsweise bei 0,2 bis 6 µm, insbesondere bei 0,2 bis 3 µm.

Bevorzugte Verwendungen des Gleitlagerverbundwerkstoffes sind solche für Gleitlagerschalen.

Beispielhafte Kupferlegierungen sind:

**Tabelle 1 (Angaben in Gew.%)**

| Beispiel | 1 | 2 | 3 | 4 | 5 |
|---|---|---|---|---|---|
| Ni | 1,9 | 1,5 | 0,8 | 3,8 | 2,8 |
| Si | 0,6 | 0,5 | 0,25 | 1,2 | 0,8 |
| Mn | 0,15 | 0,05 | 0,05 | 0,1 | 0,05 |
| Pb | <0,1 | <0,1 | <0,1 | <0,1 | <0,1 |
| Cr | | 0,15 | | | 0,15 |
| Ti | | | | 0,15 | |
| Zr | | | 0,2 | | 0,15 |
| Cu | Rest | Rest | Rest | Rest | Rest |

Ein beispielhaftes Verfahren sieht folgende Verfahrensschritte vor:
- Stranggießen einer Kupferlegierung, insbesondere Doppelstranggießen, mit einer Breite von 300 mm und einer Dicke von 10 mm zur Herstellung von Bandmaterial
- Beidseitiges Fräsen und anschließendes Aufwickeln des Bandmaterials
- Walz- und Glühoperationen bis an das Walzplattiermaß.

Das Bandmaterial wird mechanisch vorbehandelt, z. B. durch Bürsten und mittels Walzplattieren auf dem Stahlband aufgebracht. Das Stahlband hat die Breite 300 mm und eine Dicke von 4,5 mm. Das Walzplattieren mit der Kupferlegierung führt zu einem Umformgrad von 50 - 75 % entspricht.

Es folgt dann ein erster Glühschritt in einem Haubenofen bei 550°C über 2 Stunden. Im Anschluss daran wird ein erstes Walzen in einem Walzschritt durchgeführt, wobei eine Dickenreduzierung des Verbundes um 28% erfolgt, was dem Endmaß entspricht.

Anschließend wird der Verbund bei 550°C über 2 h geglüht. Danach erfolgt ein Längsteilen mit Abmessungen von 95 mm Breite x 1,56 mm Dicke.

Die Streckgrenze des Lagermetalls liegt in diesem Beispiel bei etwa 150-170 MPa.

Gemäß einer weiteren Verfahrensvariante wird die Kupferlegierung als Pulver auf das Stahlband aufgestreut und durch mindestens einen Sintervorgang bei 680°C über 10-20 min in Schutzgasatmosphäre aufgesintert.

Gemäß einer weiteren Verfahrensaltemative wird die Kupferlegierung mit einer Temperatur von 1000°C bis 1250°C auf das Stahlband aufgegossen, das vorzugsweise auf über 1000°C vorgewärmt ist. Anschließend erfolgt eine Abkühlung auf unter 100°C innerhalb von 1 bis 5 min, insbesondere in 2 bis 4 min.

Die anschließenden Walz- und Glühschritte entsprechen der Walzplattieraltemative.

Beispiele für Sputter-Schichten sind in der Tabelle 2 zusammengefasst.

**Tabelle 2 (Angaben in Gew.%)**

| Beispiel | 1 | 2 | 3 | 4 | 5 |
|---|---|---|---|---|---|
| Al | Rest | Rest | Rest | Rest | Rest |
| Sn | 22 | 35 | 25 | 10 | 20 |
| Cu | 0,7 | 1,2 | 0,7 | 0,5 | 0,5 |
| Si | | | 2,5 | | 1,5 |
| Mn | | | | 1,5 | |
| Ni | | | | 0,7 | 0,7 |

Alle genannten Gleitschichten können mit den Lagermetallschichten aus den Kupferlegierungen sowie mit den Einlaufschichten kombiniert werden.

Als Einlaufschichten auf diesen Schichtkombinationen können reine Zinn- oder Indium-Schichten, sowie alle genannten Galvanik- und Kunststoffschichten eingesetzt werden, wobei die Einlaufschicht vorzugsweise weicher als die eingesetzte Gleitschicht zu wählen ist.

## Patentansprüche

1. Gleitlagerverbundwerkstoff mit einer Trägerschicht aus Stahl, einer Lagermetallschicht aus einer Kupferlegierung, aufweisend 0,5 - 5 Gew.% Nickel, 0,2 - 2,5 Gew.% Silizium, ≤0,1 Gew.% Blei, wahlweise 0,05 - 2 Gew.% Mangan, wahlweise 0,05 - 0,4 Gew.% mindestens eines Mikrolegierungselements und Rest Kupfer und mit einer unmittelbar auf der Lagermetallschicht mittels eines PVD-Verfahrens aufgebrachten Gleitschicht.

2. Gleitlagerverbundwerkstoff nach Anspruch 1, **dadurch gekennzeichnet, dass** die Kupferlegierung 0,05 - 2 Gew.% Mangan aufweist.

3. Gleitlagerverbundwerkstoff nach Anspruch 1 oder 2, **dadurch gekennzeichnet, dass** das Gewichtsverhältnis von Nickel zu Silizium zwischen 2,5 und 5 liegt.

4. Gleitlagerverbundwerkstoff nach einem der Ansprüche 1 bis 3, **dadurch gekennzeichnet, dass** die Lagermetallschicht 0,05 - 0,4 Gew.% Mikrolegierungselemente aufweist.

5. Gleitlagerverbundwerkstoff nach Anspruch 4, **dadurch gekennzeichnet, dass** die Mikrolegierungselemente Chrom, Titan, Zirkon, Zink und/oder Magnesium sind.

6. Gleitlagerverbundwerkstoff nach einem der Ansprüche 1 bis 5, **dadurch gekennzeichnet, dass** zwischen der Lagermetallschicht und der Trägerschicht gegebenenfalls über eine Zwischenschicht eine Walzplattierverbindung besteht.

7. Gleitlagerverbundwerkstoff nach einem der Ansprüche 1 bis 5, **dadurch gekennzeichnet, dass** die Lagermetallschicht eine Sinterschicht ist.

8. Gleitlagerverbundwerkstoff nach einem der Ansprüche 1 bis 5, **dadurch gekennzeichnet, dass** die Lagermetallschicht eine Gießschicht ist.

9. Gleitlagerverbundwerkstoff nach einem der Ansprüche 1 bis 8, **dadurch gekennzeichnet, dass** die Gleitschicht mittels Sputtern aufgebracht ist.

10. Gleitlagerverbundwerkstoff nach Anspruch 9, **dadurch gekennzeichnet, dass** die Sputter-Schicht aus einer Aluminium-Zinn-Legierung, Aluminium-Zinn-Silizium-Legierung, Aluminium-Zinn-Kupfer-Legierung, einer Aluminium-Zinn-Silizium-Kupfer-Legierung oder einer Aluminium-Zinn-Nickel-Mangan-Legierung besteht.

11. Gleitlagerverbundwerkstoff nach Anspruch 10, **dadurch gekennzeichnet, dass** in den Legierungen der Zinnanteil 8-40 Gew.%, der Kupferanteil 0,5 - 4,0 Gew.%, der Siliziumanteil 0,02 - 5,0 Gew.%, der Nickelanteil 0,02 - 2,0 Gew.% und der Mangananteil 0,02 - 2,5 Gew.% beträgt.

12. Gleitlagerverbundwerkstoff nach einem der Ansprüche 1 bis 11, **dadurch gekennzeichnet, dass** auf der Gleitschicht eine Einlaufschicht vorgesehen ist.

13. Gleitlagerverbundwerkstoff nach Anspruch 12, **dadurch gekennzeichnet, dass** die Einlaufschicht als Zinn-, Blei-, Kupfer- oder Indium- oder als Kunststoffschicht ausgeführt ist.

14. Gleitlagerverbundwerkstoff nach einem der Ansprüche 1 bis 13, **dadurch gekennzeichnet, dass** die Dicke der Lagermetallschicht 0,1 - 0,8 mm beträgt.

15. Gleitlagerverbundwerkstoff nach einem der Ansprüche 1 bis 14, **dadurch gekennzeichnet, dass** die Dicke der Gleitschicht 4 - 30 µm beträgt.

16. Gleitlagerverbundwerkstoff nach einem der Ansprüche 12 bis 15, **dadurch gekennzeichnet, dass** die Dicke der Einlaufschicht 0,2 bis 12 µm beträgt.

17. Verwendung eines Gleitlagerverbundwerkstoffes nach Anspruch 1 für Gleitlagerschalen.

18. Verfahren zur Herstellung von Gleitlagerverbundmaterial insbesondere für Gleitlagerelemente, wie Gleitlagerschalen, mit folgenden Verfahrensschritten:
- Herstellen von Bandmaterial aus einer Kupferlegierung gemäß Anspruch 1, und Walzplattieren des Bandmaterials gegebenenfalls unter Verwendung einer Zwischenschicht auf eine Trägerschicht aus Stahl zur Herstellung eines Verbundes,
- thermo-mechanische Behandlung des Verbundes mit folgenden Schritten:
- mindestens ein erstes Glühen des Verbundes bei 550°C - 700°C für 2 bis 5 Stunden,
- mindestens ein erstes Walzen des Verbundes, wobei ein Umformgrad von 20 - 30 % durchgeführt wird,
- mindestens ein zweites Glühen bei 500°C - 600°C für mehr als 1 h.

19. Verfahren zur Herstellung von Gleitlagerverbundmaterial insbesondere für Gleitlagerelemente, wie Gleitlagerschalen, mit folgenden Verfahrensschritten:
- Aufbringen einer Kupferlegierung gemäß Anspruch 1 auf eine Trägerschicht aus Stahl zur Herstellung eines Verbundes,
- Sintern des Verbundes, wobei ein erstes Glühen in den Sinterprozess integriert ist,
- thermo-mechanische Behandlung des Verbundes mit folgenden Schritten:
- mindestens ein erstes Walzen des Verbundes, wobei ein Umformgrad von 20- 30 % durchgeführt wird,
- mindestens ein zweites Glühen bei 500°C - 600°C für mehr als 1 h.

20. Verfahren zur Herstellung von Gleitlagerverbundmaterial insbesondere für Gleitlagerelemente, wie Gleitiagerschalen, mit folgenden Verfahrensschritten:
- Aufgießen einer Kupferlegierung gemäß Anspruch 1 auf eine Trägerschicht aus Stahl zur Herstellung eines Verbundes,
- thermo-mechanische Behandlung des Verbundes mit folgenden Schritten:
- mindestens ein erstes Glühen des Verbundes bei 550°C - 700°C für 2 bis 5 Stunden,
- mindestens ein erstes Walzen des Verbundes, wobei ein Umformgrad von 20 - 30 % durchgeführt wird,
- mindestens ein zweites Glühen bei 500°C - 600°C für mehr als 1 h.

21. Verfahren nach einem der Ansprüche 18 bis 20, **dadurch gekennzeichnet, dass** nach dem zweiten Glühen ein zweites Walzen mit einem Umformgrad von max. 30 % mit einem anschließenden dritten Glühen bei Temperaturen >500°C über mindestens 1 h angeschlossen wird.

22. Verfahren zur Herstellung von Gleitlagerelementen,
insbesondere von Gleitlagerschalen, **dadurch gekennzeichnet,**
**dass** ein Verbund nach einem der Ansprüche 18 bis 21 hergestellt wird,
**dass** vom Verbund Platinen abgetrennt werden,
**dass** diese Platinen zu Gleitlagerelementen umgeformt werden, und
**dass** eine Gleitschicht aufgesputtert wird.

23. Verfahren nach Anspruch 22, **dadurch gekennzeichnet, dass** nach dem Sputtern der Gleitschicht eine Einlaufschicht aufgebracht wird.

## Claims

1. Slide bearing composite material having a carrier layer of steel, a bearing-metal layer composed of a copper alloy having 0.5 - 5% by weight of nickel, 0.2 - 2.5% by weight of silicon, ≤0.1% by weight of lead, optionally 0.05 - 2% by weight of manganese, optionally 0.05 - 0.4% by weight of at least one microalloying element and remainder copper and having a sliding layer applied directly to the bearing-metal layer by means of a PVD process.

2. Slide bearing composite material according to claim 1, **characterised in that** the copper alloy has 0.05 - 2% by weight of manganese.

3. Slide bearing composite material according to claim 1 or 2, **characterised in that** the ratio by weight of nickel to silicon is from 2.5 to 5.

4. Slide bearing composite material according to any one of claims 1 to 3, **characterised in that** the bearing-metal layer has 0.05 - 0.4% by weight of microalloying elements.

5. Slide bearing composite material according to claim 4, **characterised in that** the microalloying elements are chromium, titanium, zirconium, zinc and/or magnesium.

6. Slide bearing composite material according to any one of claims 1 to 5, **characterised in that** a roll-bonded connection exists between the bearing-metal layer and the carrier layer, optionally by way of an intermediate layer.

7. Slide bearing composite material according to any one of claims 1 to 5, **characterised in that** the bearing-metal layer is a sintered layer.

8. Slide bearing composite material according to any one of claims 1 to 5, **characterised in that** the bearing-metal layer is a cast layer.

9. Slide bearing composite material according to any one of claims 1 to 8, **characterised in that** the sliding layer is applied by sputtering.

10. Slide bearing composite material according to claim 9, **characterised in that** the sputtered layer is composed of an aluminium-tin alloy, aluminium-tin-silicon alloy, aluminium-tin-copper alloy, an aluminium-tin-silicon-copper alloy or an aluminium-tin-nickel-manganese alloy.

11. Slide bearing composite material according to claim 10, **characterised in that**, in the alloys, the proportion of tin is 8 - 40% by weight, the proportion of copper is 0.5 - 4.0% by weight, the proportion of silicon is 0.02 - 5.0% by weight, the proportion of nickel is 0.02 - 2.0% by weight and the proportion of manganese is 0.02 - 2.5% by weight.

12. Slide bearing composite material according to any one of claims 1 to 11, **characterised in that** a running-in layer is provided on the sliding layer.

13. Slide bearing composite material according to claim 12, **characterised in that** the running-in layer is in the form of a tin, lead, copper or indium layer or in the form of a plastics layer.

14. Slide bearing composite material according to any one of claims 1 to 13, **characterised in that** the thickness of the bearing-metal layer is 0.1 - 0.8 mm.

15. Slide bearing composite material according to any one of claims 1 to 14, **characterised in that** the thickness of the sliding layer is 4 - 30 µm.

16. Slide bearing composite material according to any one of claims 12 to 15, **characterised in that** the thickness of the running-in layer is from 0.2 to 12 µm.

17. Use of a slide bearing composite material according to claim 1 for slide bearing shells.

18. Method for the manufacture of slide bearing composite material, especially for slide bearing elements, such as slide bearing shells, having the following method steps:
- manufacture of strip material from a copper alloy according to claim 1, and roll-bonding of the strip material, optionally with the use of an intermediate layer, onto a carrier layer of steel for the manufacture of a composite,
- thermo-mechanical treatment of the composite, having the following steps:
- at least one first annealing of the composite at 550°C - 700°C for 2 to 5 hours,
- at least one first rolling of the composite, a degree of deformation of 20 - 30 % being carried out,
- at least one second annealing at 500°C - 600°C for more than 1 h.

19. Method for the manufacture of slide bearing composite material, especially for slide bearing elements, such as slide bearing shells, having the following method steps:
- application of a copper alloy according to claim 1 to a carrier layer of steel for the manufacture of a composite,
- sintering of the composite, a first annealing being integrated in the sintering process,
- thermo-mechanical treatment of the composite, having the following steps:
- at least one first rolling of the composite, a degree of deformation of 20 - 30% being carried out,
- at least one second annealing at 500°C - 600°C for more than 1 h.

20. Method for the manufacture of slide bearing composite material, especially for slide bearing elements, such as slide bearing shells, having the following method steps:
- casting a copper alloy according to claim 1 onto a carrier layer of steel for the manufacture of a composite,
- thermo-mechanical treatment of the composite, having the following steps:
- at least one first annealing of the composite at 550°C - 700°C for 2 to 5 hours,
- at least one first rolling of the composite, a degree of deformation of 20 - 30% being carried out,
- at least one second annealing at 500°C - 600°C for more than 1 h.

21. Method according to any one of claims 18 to 20, **characterised in that** the second annealing is followed by a second rolling with a degree of deformation of max. 30%, with a subsequent third annealing at temperatures >500°C
for
a period of at least 1 h.

22. Method for the manufacture of slide bearing elements, especially slide bearing shells, **characterised in that**
a composite is manufactured according to any one of claims 18 to 21,
bars are cut from the composite,
those bars are deformed to form slide bearing elements and
a sliding layer is applied by sputtering.

23. Method according to claim 22, **characterised in that** a running-in layer is applied after the sputtering of the sliding layer.

## Revendications

1. Matériau composite pour paliers lisses avec une couche de support en acier, une couche de métal pour palier en alliage de cuivre, présentant 0,5 - 5 % en poids de nickel, 0,2 - 2,5 % en poids de silicium, ≤ 0,1% en poids de plomb, au choix 0,05 - 2 % en poids de manganèse, au choix 0,05 - 0,4 % en poids d'au moins un élément de microalliage et de cuivre résiduel et avec une couche de glissement appliquée directement sur la couche de métal pour palier au moyen d'un procédé PVD.

2. Matériau composite pour paliers lisses selon la revendication 1, **caractérisé en ce que** l'alliage de cuivre présente 0,05 - 2 % en poids de manganèse.

3. Matériau composite pour paliers lisses selon la revendication 1 ou 2, **caractérisé en ce que** le rapport de poids entre nickel et silicium est compris entre 2,5 et 5.

4. Matériau composite pour paliers lisses selon une des revendications 1 à 3, **caractérisé en ce que** la couche de métal pour palier présente 0,05 - 0,4 % en poids d'au moins un élément de microalliage.

5. Matériau composite pour paliers lisses selon la revendication 4, **caractérisé en ce que** les éléments de microalliage sont du chrome, du titane, du zirconium, du zinc et/ou du magnésium.

6. Matériau composite pour paliers lisses selon une des revendications 1 à 5, **caractérisé en ce qu'**il existe une liaison par placage par laminage, le cas échéant via une couche intermédiaire, entre la couche de métal pour palier et la couche de support.

7. Matériau composite pour paliers lisses selon une des revendications 1 à 5, **caractérisé en ce que** la couche de métal pour palier est une couche frittée.

8. Matériau composite pour paliers lisses selon une des revendications 1 à 5, **caractérisé en ce que** la couche de métal pour palier est une couche coulée.

9. Matériau composite pour paliers lisses selon une des revendications 1 à 8, **caractérisé en ce que** la couche de glissement est appliquée par pulvérisation.

10. Matériau composite pour paliers lisses selon la revendication 9, **caractérisé en ce que** la couche appliquée par pulvérisation est composée d'un alliage aluminium-étain, d'un alliage aluminium-étain-silicium, d'un alliage aluminium-étain-cuivre, d'un alliage aluminium-étain-silicium-cuivre ou d'un alliage aluminium-étain-nickel-manganèse.

11. Matériau composite pour paliers lisses selon la revendication 10, **caractérisé en ce que** dans les alliages, la part d'étain s'élève à 8 - 40 % en poids, la part de cuivre à 0,5 - 4,0 % en poids, la part de silicium à 0,02 - 5,0 % en poids, la part de nickel à 0,02 - 2,0 % en poids et la part de manganèse à 0,02 - 2,5 % en poids.

12. Matériau composite pour paliers lisses selon une des revendications 1 à 11, **caractérisé en ce qu'**une couche de rodage est prévue sur la couche de glissement.

13. Matériau composite pour paliers lisses selon la revendication 12, **caractérisé en ce que** la couche de rodage est réalisée sous la forme d'une couche en étain, plomb, cuivre ou indium ou sous la forme d'une couche en matière plastique.

14. Matériau composite pour paliers lisses selon une des revendications 1 à 13, **caractérisé en ce que** l'épaisseur de la couche de métal pour palier est comprise entre 0,1 et 0,8 mm.

15. Matériau composite pour paliers lisses selon une des revendications 1 à 14, **caractérisé en ce que** l'épaisseur de la couche de glissement est comprise entre 4 et 30 µm.

16. Matériau composite pour paliers lisses selon une des revendications 12 à 15, **caractérisé en ce que** l'épaisseur de la couche de rodage est comprise entre 0,2 et 12 µm.

17. Utilisation d'un matériau composite pour paliers lisses selon la revendication 1 pour des coquilles de paliers lisses.

18. Procédé de fabrication d'un matériau composite pour paliers lisses, en particulier pour des éléments de paliers lisses tels que coquilles de paliers lisses, présentant les étapes suivantes :
- fabrication d'un matériau en bande à partir d'un alliage de cuivre selon la revendication 1, et placage par laminage du matériau en bande, le cas échéant en utilisant une couche intermédiaire, sur une couche de support en acier pour fabriquer un composite,
- traitement thermomécanique du composite présentant les étapes suivantes :
- au moins un premier recuit du composite à 550 °C - 700 °C pendant 2 à 5 heures,
- au moins un premier laminage du composite, un degré de déformation de 20 % - 30 % étant réalisé,
- au moins un deuxième recuit à 500 °C - 600 °C pendant plus d'une heure.

19. Procédé de fabrication d'un matériau composite pour paliers lisses, en particulier pour des éléments de paliers lisses tels que coquilles de paliers lisses, présentant les étapes suivantes :
- application d'un alliage de cuivre selon la revendication 1 sur une couche de support en acier pour fabriquer un composite,
- frittage du composite, un premier recuit étant intégré dans le processus de frittage,
- traitement thermomécanique du composite présentant les étapes suivantes :
- au moins un premier laminage du composite, un degré de déformation de 20 % - 30 % étant réalisé,
- au moins un deuxième recuit à 500 °C - 600 °C pendant plus d'une heure.

20. Procédé de fabrication d'un matériau composite pour paliers lisses, en particulier pour des éléments de paliers lisses tels que coquilles de paliers lisses, présentant les étapes suivantes :
- coulage d'un alliage de cuivre selon la revendication 1 sur une couche de support en acier pour fabriquer un composite,
- traitement thermomécanique du composite présentant les étapes suivantes :
- au moins un premier recuit du composite à 550 °C - 700 °C pendant 2 à 5 heures,
- au moins un premier laminage du composite, un degré de déformation de 20 % - 30 % étant réalisé,
- au moins un deuxième recuit à 500 °C - 600 °C pendant plus d'une heure.

21. Procédé selon une des revendications 18 à 20, **caractérisé en ce qu'**après le deuxième recuit, un deuxième laminage avec un degré de déformation de 30 % max. suivi d'un troisième recuit à des températures > 500 °C pendant au moins une heure est effectué.

22. Procédé de fabrication d'éléments de paliers lisses, en particulier de coquilles de paliers lisses, **caractérisé en ce**
**qu'**un composite selon une des revendications 18 à 21 est fabriqué,
**que** des platines sont séparées du composite,
**que** ces platines sont transformées en éléments de paliers lisses et
**qu'**une couche de glissement est appliquée par pulvérisation.

23. Procédé selon la revendication 22, **caractérisé en ce qu'**une couche de rodage est appliquée après l'application par pulvérisation de la couche de glissement.
